(19)

Europäisches
Patentamt
European
Patent Office
Office européen
des brevets

(11)　**EP 4 167 089 A1**

(12)　**EUROPEAN PATENT APPLICATION**

(43) Date of publication:
**19.04.2023　Bulletin 2023/16**

(21) Application number: **21202205.7**

(22) Date of filing: **12.10.2021**

(51) International Patent Classification (IPC):
**G06F 9/50** *(2006.01)*　　**G06F 30/20** *(2020.01)*
**G06F 30/27** *(2020.01)*

(52) Cooperative Patent Classification (CPC):
**G06F 9/50; G06F 30/20; G06F 30/27**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Fraunhofer-Gesellschaft zur Förderung
der angewandten Forschung e.V.
80686 München (DE)**

(72) Inventor: **CHARLISH, Alexander
53343 Wachtberg (DE)**

(74) Representative: **2SPL Patentanwälte PartG mbB
Landaubogen 3
81373 München (DE)**

(54)　**METHOD TO DISTRIBUTE RESOURCES AMONG A GROUP OF TASKS, METHOD FOR
MAPPING TASK STATES OF A TASK TO PARAMETERS OF A RESOURCE-UTILITY
FUNCTION, APPARATUS FOR DISTRIBUTING RESOURCES AMONG A GROUP OF TASKS**

(57)　A method to distribute resources among a group of tasks is provided. The method includes determining at least one parameter of a resource-utility function for a task of the group of tasks based on a task state of the task and determining a resource to be consumed by the task based on the resource-utility function.

100

determining at least one parameter of a
resource-utility function for a task of a
group of tasks based on a task state of the
task

110

determining a resource to be consumed
by the task based on the resource-utility
function

120

**Fig. 1**

EP 4 167 089 A1

**Description**

**Field**

The present disclosure relates to resource allocation. Examples relate to a method to distribute resources among a group of tasks, a method for mapping task states of a task to parameters of a resource-utility function, and an apparatus for distributing resources among a group of tasks.

**Background**

When limited resources have to be allocated to multiple tasks, it may be a complex process to optimize a utility the tasks achieve which demands high computational effort. However, especially real-time systems require a fast and efficient resource allocation. Hence, there may be a demand for an improved resource allocation.

**Summary**

The demand may be satisfied by the subject matter of the appended claims.

According to a first aspect, the present disclosure provides a method to distribute resources among a group of tasks. The method comprises determining at least one parameter of a re-source-utility function for a task of the group of tasks based on a task state of the task and determining a resource to be consumed by the task based on the resource-utility function.

According to a second aspect, the present disclosure provides a method for mapping task states of a task to parameters of a resource-utility function. The method comprises training a mapping model based on a training dataset of at least one exemplary task state of the task and at least one corresponding parameter, wherein the trained mapping model maps the task states of the task to the parameters.

According to a third aspect, the present disclosure provides an apparatus for distributing resources among a group of tasks. The apparatus comprises processing circuitry configured to determine at least one parameter of a resource-utility function for a task of the group of tasks based on a task state of the task and determine a resource to be consumed by the task based on the resource-utility function.

According to a fourth aspect, the present disclosure provides a non-transitory machine-readable medium having stored thereon a program having a program code for performing the method to distribute resources among a group of tasks as described herein, when the program is executed on a processor or a programmable hardware.

According to a fifth aspect, the present disclosure provides a program having a program code for performing the method to distribute resources among a group of tasks as described herein, when the program is executed on a processor or a programmable hardware.

According to a sixth aspect, the present disclosure provides a non-transitory machine-readable medium having stored thereon a program having a program code for performing the method for mapping task states of a task to parameters of a resource-utility function as described herein, when the program is executed on a processor or a programmable hardware.

According to a seventh aspect, the present disclosure provides a program having a program code for performing the method for mapping task states of a task to parameters of a resource-utility function as described herein, when the program is executed on a processor or a programmable hardware.

**Brief description of the Figures**

Some examples of apparatuses and/or methods will be described in the following by way of example only, and with reference to the accompanying figures, in which

Fig. 1 illustrates a flowchart of an example of a method to distribute resources among a group of tasks;

Fig. 2 illustrates a flowchart of an example of a method for mapping task states of a task to parameters of a resource-utility function;

Fig. 3 illustrates an example of an apparatus for distributing resources among a group of tasks;

Fig. 4a, Fig. 4b illustrate a flowchart of an example of a method to distribute resources among a group of tasks in a combined offline-online process and in a solely online process;

Fig. 5 illustrates a flowchart of an example of a method to distribute resources among a group of tasks;

Fig. 6a, Fig. 6b, Fig. 6c illustrate a first example of a resource function, a quality function, and a utility function;

Fig. 7a, Fig. 7b, Fig. 7c illustrate a second example of a resource function, a quality function, and a utility function; and

Fig. 8a, Fig. 8b illustrate a first exemplary resource-against-utility plot and a second exemplary resource-against-utility plot.

**Detailed Description**

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

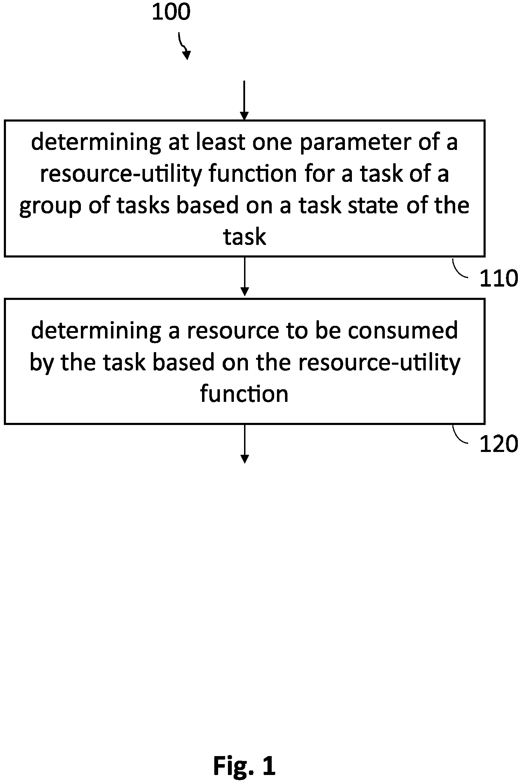

**Fig. 1** illustrates a flowchart of an example of a method 100 to distribute resources among a group of tasks. The method 100 may be used for a quality-of-service (QoS) based resource allocation, e.g., in computing, radar, or telecommunication systems. Hereinafter, details of the method 100 may be described by means of an exemplary multifunctional radio frequency system. In particular, the method 100 may be for the multifunctional radio frequency system, i.e., the method 100 may be performed by the multifunctional radio frequency system, or the method 100 may be connected to an operation of the multifunctional radio frequency system. For instance, an output of the method 100 may be used as an input of the multifunctional radio frequency system or vice versa.

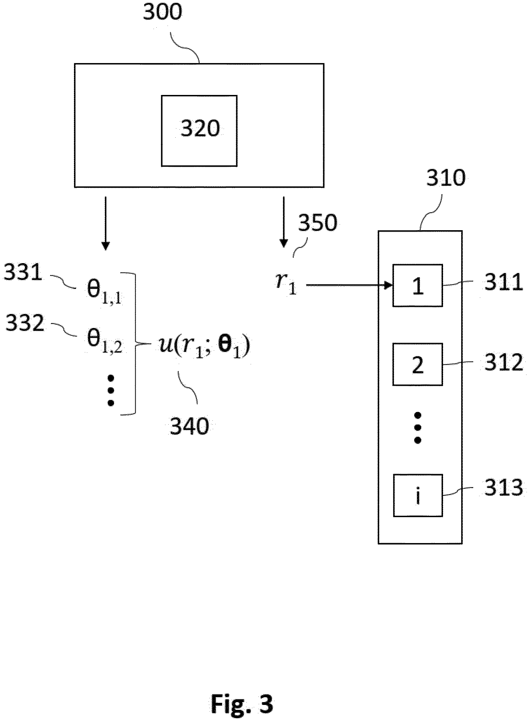

The method 100 may be performed by an apparatus for distributing resources among a group of tasks, such as the apparatus described with reference to Fig. 3. The method 100 may be performed by processing circuitry of the apparatus which may be integrated into or coupled to the multifunctional radio frequency system.

The multifunctional radio frequency system may be any radio frequency system (e.g., a radar system) capable of performing multiple functions and, thus, replacing several individual function-dedicated radio frequency systems. The functions performed by the multifunctional radio frequency system may be described by task classes. Non-limiting examples for task classes are active target tracking, search, target confirmation, communications, electronic surveillance, or electronic attack. The multifunctional radio frequency system may realize the functions by setting a configuration (control parameters) of active phased-array antennas (radio frequency sensors), i.e., controlling the antennas to emit a radio frequency signal with a specific beam position, dwell time, waveform, or energy (as specified by the configuration).

The multifunctional radio frequency system may perform tasks of one or more task classes. Tasks are to be understood as concrete realizations of functions. Examples of tasks in different task classes are active target tracking of a specific target, searching a specific volume, confirming a specific target, communicating a specific message, electronic surveillance for a specific frequency and angle region, or electronic attack against a specific emitter. Tasks may require repetition or may be completed during a fixed short time interval. So, tasks may have a life duration between predefined start and stop times and may be executed multiple times during this life duration.

A specific task may correspond to a respective configuration of at least one antenna of the multifunctional radio frequency system. The respective configuration may be selected according to a task state of the specific task. The task state may be a vector of values that describe relevant information about the task, e.g., influential variables, characteristics, or requirements of the task. The relevant information is considered relevant in the sense that it may influence the selection of the configuration. The values may be probabilistic, i.e., parameters of a probability density function. For example, a task state of a task of active target tracking may comprise values describing tracking accuracy quality requirements, estimates of range, range rate and angle of a target and associated covariances. More examples for such relevant information for different tasks and task classes are listed in table 1 below.

Table 1: Examples of task states

| Task class | Task | Task state (Examples) |
|---|---|---|
| Active Target Tracking | Target 1<br>Target 2<br>...<br>Target 50 | - Estimates of target kinematic parameters, radar cross section<br><br>- Covariance associated with estimates<br>- Parameters of motion model (e.g., Interacting multiple model)<br>- Task quality requirements and importance weighting |
| Search | Search volume 1<br>Search volume 2<br>...<br>Search volume 10 | - Search volume extent (angle, range and range rate limits, or Cartesian volume)<br>- Parameters of a density describing the distribution of undetected targets<br>- Current target detection or acquisition range<br>- Task quality requirements and importance weighting |
| Electronic Surveillance (ES) | ES 1<br>ES 2<br>...<br>ES4 | - Surveillance extent, i.e., frequency bandwidth and angles<br><br>- Parameters of expected emitters<br>- Undetected target density<br>- Task quality requirements and importance weighting |

The multifunctional radio frequency system may operate several tasks in parallel (at the same time). For instance, the multifunctional radio frequency system may operate the tasks "Target 1", "Target 2", "Search Volume 1", and "ES 1" (from Table 1), each of them with a respective task state, at the same time. A totality of open tasks, i.e., all tasks which are in operation (or in waiting queue) at a certain point in time and not completed, is referred to as the group of tasks.

A task may require for its operation a resource depending on the task state of the task. There may be resources of different types such as time, power, communication bandwidth, computing capacity, or signal bandwidth. For each of the types of resources, there may be a limiting budget (time budget, energy budget, computing budget, etc.) which is available for distributing resources among the group of tasks.

The multifunctional radio frequency system may assign a certain resource, e.g., a certain share or percentage of the limiting budget or an absolute value, to each of the (active) tasks of the group of tasks. In other words, the multifunctional radio frequency system may distribute resources of a certain type among the group of tasks without the resources of the certain type exceeding a predefined threshold (the limiting budget) for the certain type.

A distribution of the resources among the group of tasks for a certain point in time may be described by a resource allocation. For example, if the group of tasks comprises two (active) tasks (task 1 and task 2) at a certain point in time, and task 1 receives 20% of a limiting budget (of a certain type of resources) and task 2 receives 80% of the limiting budget, then a corresponding resource allocation may be represented as a vector of scalar values, e.g., as $[0.2\ 0.8]^T$.

In other examples, the group of tasks may comprise a different number of tasks than given in the above-mentioned example. The group of tasks may comprise $N_T \geq 1$ tasks. The resources (of a certain type of resources) distributed among the group of tasks do not necessarily sum up to 100% of the limiting budget. The group of tasks may comprise inactive tasks, i.e., tasks which are in waiting queue and do not consume any resource. In other examples, there may a respective resource allocation for different types of resources.

Since operation requirements, e.g., a number of open tasks and/or task states of the open tasks, may change over time, the multifunctional radio frequency system may be configured to react dynamically to the operation requirements. Consequently, a specific resource allocation may be required for a specific time duration (e.g., 1 second). Therefore, the multifunctional radio frequency system may determine resource allocations sequentially and continuously to define a schedule of resource allocations.

An objective of the method 100 may be determining - in a time-efficient manner - a suitable resource allocation for efficient usage of the limiting budgets and high performance of the tasks. The performance of a task may be rated based on a utility of the task.

Referring back to Fig. 1, the method 100 comprises determining 110 at least one parameter of a resource-utility function for a task of the group of tasks based on a task state of the task. The at least one parameter is determined based on the (current) task state of the task. The parameters may vary depending on task states of the task but may be fixed during a process of one resource allocation, i.e., fixed for a specific time interval of the resource allocation. The resource-utility function maps from a resource of the task to a corresponding utility, i.e., the resource-utility function uses the resource as input and outputs the corresponding utility. The resource-utility function is a parameterized (parametric) function which describes a mathematical relationship between resources and corresponding utilities in dependence of the at least one parameter which is an unspecified variable independent of an input of the resource-utility function.

The resource-utility function may be represented mathematically by Equation 1:

$$u_i = u(r_i; \boldsymbol{\theta}_i) \qquad\qquad\qquad \text{Equation 1}$$

u of Equation 1 is the resource-utility function. $u_i$ is a utility value that the resource-utility function outputs for a task $i$ of the group of tasks. $r_i$ is a resource allocated to the task $i$, and $\theta_i$ is a vector describing the at least one parameter of the resource-utility function.

An example of a resource-utility function is an exponential function described by Equation 2:

$$u(r_i; \boldsymbol{\theta}_i) = 1 - \theta_{i,1} \exp(-\theta_{i,2}\, r_i); \text{ where } \boldsymbol{\theta}_i = [\theta_{i,1}\ \theta_{i,2}]^T \qquad\qquad \text{Equation 2}$$

The resource-utility function as described by Equation 2 is not specific for the task or task class, but the parameters $\theta_i$ of the resource-utility function are specific for the task state.

Alternatively, the resource-utility function may be any other function, e.g., a different exponential function than given in Equation 2, a linear function, a power function, or a polynomial function.

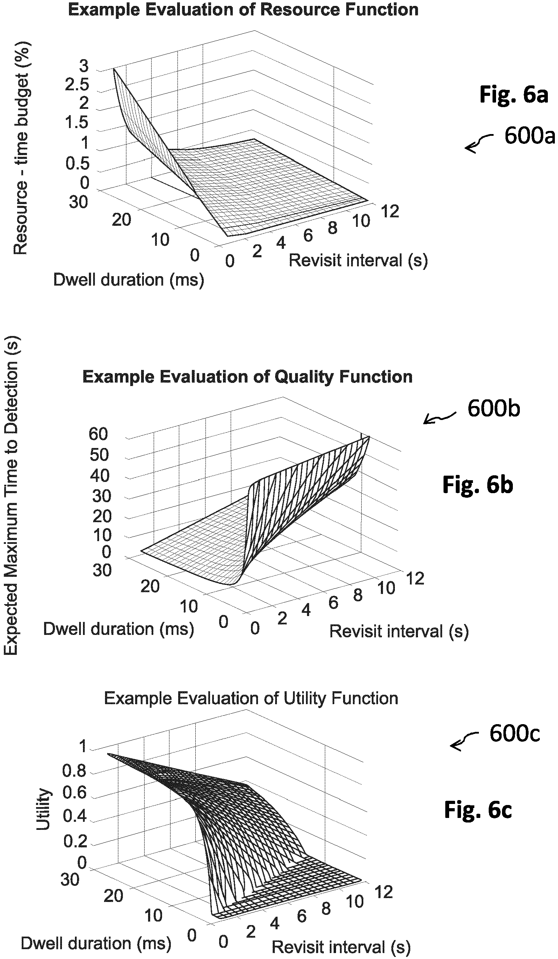

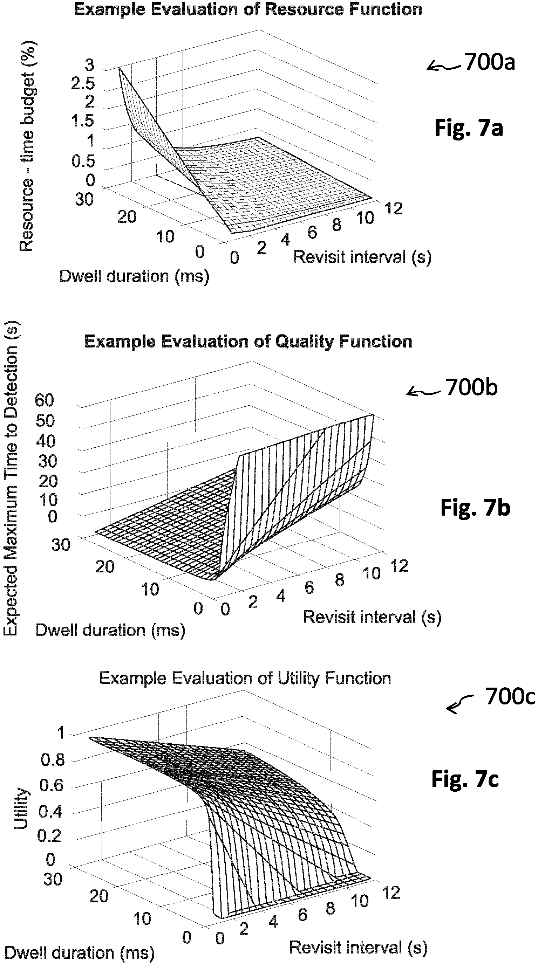

The resource-utility function may be advantageous since it maps (directly) from a resource allocated to the task to the corresponding utility. The resource-utility function may replace a discretization for evaluating a resource function, quality function and utility function. In some examples, an evaluation of the resource function, the quality function and the utility function may be performed offline (e.g., before operating or commissioning the multifunction radio frequency system or externally of the multifunctional radio frequency system). In this case, only the resource-utility function may be required online (during operation). Thus, the method 100 may be more time-efficient compared to existing resource allocation methods such as Q-RAM. An example of a resource function, a quality function, and a utility function are explained with reference to Fig. 6a-c and Fig. 7a-c.

The resource-utility function may be parameterized by any number $m \geq 1$ of parameters. Determining 110 the at least one parameter of the resource-utility function may comprise determining the m parameters of the resource-utility function.

In some examples, the resource-utility function is a concave continuous function. Then, a gradient of the resource-utility function may be decreasing and a second derivative of the resource-utility function may be less than or equal to 0. Generally, the resource-utility function may be any parameterized function suitable to map from a resource of the task to a corresponding utility.

Determining 110 the at least one parameter of the resource-utility function may comprise determining the at least one parameter such that the resource-utility function outputs a high (or Pareto-efficient or highest) utility for a given resource.

In some examples, the resource-utility function approximates a convex hull around at least one resource-utility instantiation of the task. In particular, the resource-utility function (with the determined parameter) may approximate a concave majorant (upper limit) of the convex hull. The concave majorant may correspond to a high (or Pareto-efficient or highest) utility that may be achieved by the task with a given resource.

The resource-utility instantiation may be a representation of a resource of a task and a corresponding utility of the task in a resource-against-utility plot. It is to be noted that usually several resource-utility instantiations may be required to get suitable results. Generally, there may be a $\geq 1$ resource-utility instantiations.

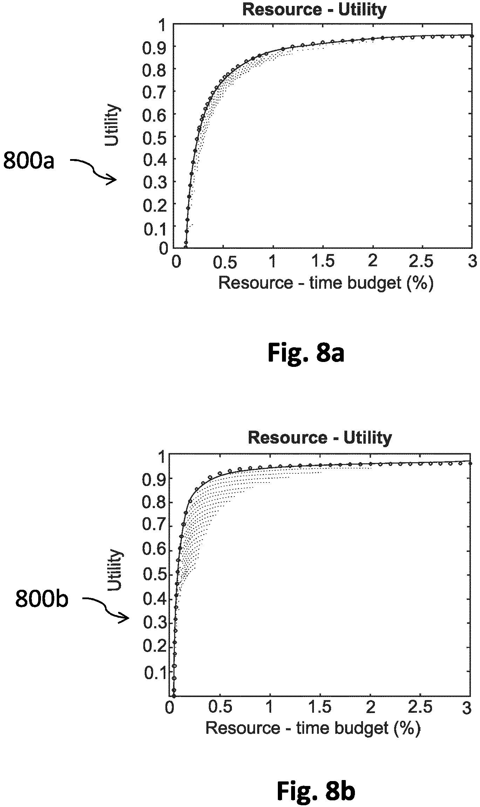

An example of the resource-utility function approximating a concave majorant of exemplary resource-utility instantiations is illustrated in Fig. 8a and Fig. 8b.

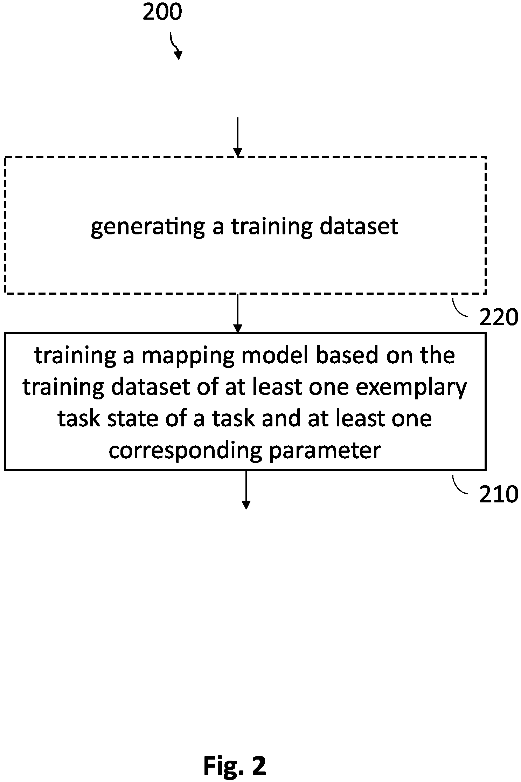

In some examples, determining 110 the at least one parameter of the resource-utility function comprises mapping the task state of the task to the at least one parameter using a mapping model. The mapping model may be, e.g., a function, a function approximation, a look-up table, or a machine learning model. The mapping model may be constructed offline, e.g. by a method for mapping task states of a task to parameters of a resource-utility function as will be described below with reference to Fig. 2.

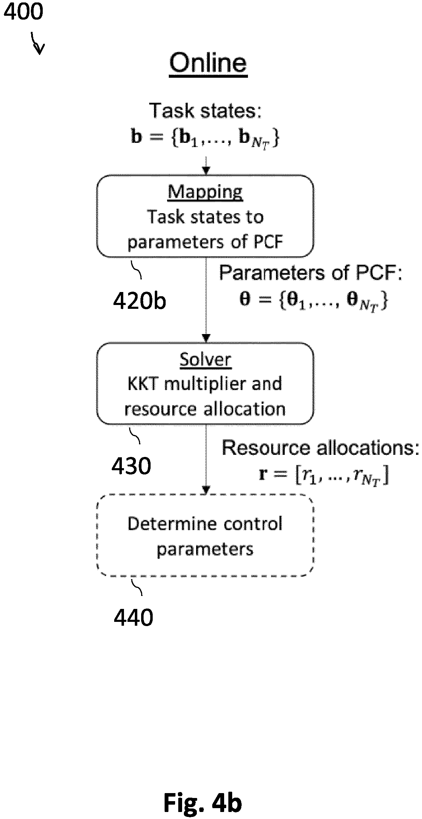

In other examples, mapping the task state of the task to the at least one parameter comprises determining at least one resource-utility instantiation for the task state, approximating a convex hull around the at least one resource-utility instantiation and determining the at least one parameter based on the approximated convex hull. For instance, determining 110 the at least one parameter of the resource-utility function may comprise determining the at least one parameter such that the resource-utility function is fitted to the concave majorant. In this case, no mapping model constructed offline is needed as will be described below with reference to Fig. 4b.

For instance, a concave majorant of the convex hull may be approximated by evaluating a resource function, a quality function, and a utility function for a limited number of control parameters. Parameters of the resource-utility function may then be determined by fitting the resource-utility function to a concave majorant of resulting resource-utility instantiations. Fitting may relate to a mathematical method for constructing the at least one parameter of the resource-utility function such that the resource-utility function has a suitable fit to data points of the approximated concave majorant.

The control parameters may describe a configuration of antennas of the multifunctional radio frequency system. The control parameters may have an impact on the resource that the task requires and the utility that the task achieves. Typical examples of control parameters are dwell time (estimated time elapsing over a single execution of the task) or revisit interval time (time duration between two successive executions of the task). The control parameters of each task may be represented as a vector of values. Each task class may exhibit different control parameters.

Referring back to Fig. 1, the method 100 further comprises determining 120 a resource to be consumed by the task based on the resource-utility function. The resource to be consumed by the task may be determined based on resources to be consumed by further tasks of the group of tasks.

In some examples, determining 120 the resource to be consumed by the task may comprise determining resources to be consumed by the further tasks of the group of tasks without the resources to be distributed among the group of tasks exceeding a predefined threshold. The predefined threshold may be a maximum (limiting) budget of the resources (or of resources of a specific type).

In some examples, determining 120 the resource to be consumed by the task may comprise solving a constrained optimization problem for finding a high total utility for the group of tasks. The optimization problem may be constrained in the sense that the predefined threshold shall not be exceeded. Determining the resources to be consumed by the further tasks of the group of tasks may comprise solving a Lagrangian function for finding a maximum of a combined resource-utility function of the group of tasks. The maximum may be a maximum total utility of the group of tasks. The Lagrangian function is a function with Lagrange multipliers used for constrained optimization problems.

The combined resource-utility function may be a set of resource-utility functions wherein each of the resource-utility functions is associated to a respective (active) task of the group of tasks. In some examples, the resource-utility functions may be task class specific, i.e., tasks of the same task class may be associated to the same resource-utility function parameterized with at least one parameter according to task states of the tasks of the same task class. In other words, tasks of the same task class and with different task states may be associated to the same resource-utility function parameterized with different parameters, e.g., at least one respective parameter for each of the task states.

For each of the (active) tasks of the group of tasks, at least one respective parameter of a respective resource-utility function may be determined based on task states of the tasks.

The constrained optimization problem is represented mathematically by Equation 3:

$$\max_{\boldsymbol{r}} \sum_{i=1}^{N_T} u(r_i; \boldsymbol{\theta}_i)$$

$$subject\ to\ \sum_{i=1}^{N_T} r_i - R \le 0 \qquad\qquad \text{Equation 3}$$

where $N_T$ is the number of tasks, $\boldsymbol{r}=[r_1 \dots r_{NT}]^{\boldsymbol{T}}$ is a resource allocation and R is a scalar value representing the predefined threshold.

The Lagrangian function L is represented mathematically by Equation 4:

$$\mathcal{L}(\boldsymbol{r}, \lambda) = -\sum_{i=1}^{N_T} u(r_i; \boldsymbol{\theta}_i) + \lambda\left(\sum_{i=1}^{N_T} r_i - R\right) \qquad\qquad \text{Equation 4}$$

where $\lambda$ is the Lagrangian multiplier such as a Karush-Kuhn-Tucker (KKT) multiplier. Solving the Lagrangian function may comprise using at least one of an analytical solver, a closed form solver, a numerical solver, i.e., a dual problem and a stationarity condition associated with the Lagrangian function may be solved in analytic form, closed form, or with numerical methods. A selection of the solver may depend on the resource-utility function. In case a closed form or an analytical expression is not found for the resource-utility function, numerical methods may be used.

Solving the Lagrangian function may be achieved by solving for $\lambda$ ($\lambda \geq 0$) Equation 5:

$$\sum_{i=1}^{N_T} \frac{\partial g_i(\lambda)}{\partial \lambda} = R\ ; \qquad\qquad \text{Equation 5}$$

where gi (λ) is described by Equation 6:

$$g_i(\lambda) = \min_{r_i}\{-u(r_i; \boldsymbol{\theta}_i) + \sum_{i=1}^{N_T}\lambda r_i\} \qquad \text{Equation 6}$$

The solver may solve for $r_i$ Equation 7:

$$\frac{\partial u(r_i; \boldsymbol{\theta}_i)}{\partial r_i} = \lambda; \forall i \in \{1, \dots, N_T\} \qquad \text{Equation 7}$$

In some examples, the method 100 further comprises determining at least one control parameter of the task based on the determined resource to be consumed by the task. This may be an additional step of the method 100. Determining the at least one control parameter of the task may comprise mapping from the resource allocated to the task to the at least one control parameter (a control parameter instantiation). Mapping from the resource allocated to the task to the at least one control parameter may be performed using a function, a function approximation, a machine learning model produced based on learning techniques (e.g., supervised learning, reinforcement learning), a non-linear optimizer, a neural network, a regression analysis, or a look-up table with or without interpolation.

In some examples, the resources to be distributed among the group of tasks are of different types. In this case, the method 100 may further comprise determining, for each of the different types, a respective resource to be consumed by the task based on the resource-utility function. The resource-utility function $u(r_i; \theta_i)$ may then have multiple inputs.

A corresponding constrained optimization problem is represented mathematically by Equation 8:

$$\max_{\boldsymbol{r}} \sum_{i=1}^{N_T} u(\boldsymbol{r}_i; \boldsymbol{\theta}_i)$$

$$subject\ to\ \sum_{i=1}^{N_T} r_{i,k} - R_k \leq 0 ; \forall k \in \{1, \dots, N_R\} \qquad \text{Equation 8}$$

where $N_R \geq 1$ is the number of types, $R_k$ is a scalar value representing a predefined threshold (maximum budget) for the type $k$ of the types of resources. $\boldsymbol{r}=[\boldsymbol{r}_1, \dots, \boldsymbol{r}_{NT}]^T$ is a vector comprising a respective resource allocation for each task and type of resource, $\boldsymbol{r}_i=[r_i, 1, \dots, r_{i,NR}]$ comprises resource allocations for each type of resource to the task $i$. $r_{i,k}$ is a scalar quantity representing a resource of type $k$ to be allocated to the task $i$.

If different types of resources are to be distributed among the group of tasks, mapping a task state of the task to the at least one parameter of the resource-utility function may generate an output with more parameters than in a single-type resource allocation.

A solver for Equation 8 may solve for each $\lambda_k \geq 0$ Equation 9:

$$\sum_{i=1}^{N_T} \frac{\partial g_i(\lambda_k)}{\partial \lambda_k} = R_k ; \forall k \in \{1, \dots, N_R\} \qquad \text{Equation 9}$$

where $\lambda_k$ is the KKT multiplier associated with resource $k$ and where gi ($\lambda_k$) is described by Equation 10:

$$g_i(\lambda_k) = \min_{r_i}\{-u(\boldsymbol{r}_i; \boldsymbol{\theta}_i) + \sum_{i=1}^{N_T}\lambda_k r_{i,k}\} \qquad \text{Equation 10}$$

The solver may solve for $r_{i,k}$ Equation 11:

$$\frac{\partial u(\boldsymbol{r}_i; \boldsymbol{\theta}_i)}{\partial r_{i,k}} = \lambda_k ; \forall i, k \qquad \text{Equation 11}$$

If different types of resources are to be distributed among the group of tasks, it may be harder to find a closed form or analytic solution. So, a set of non-linear simultaneous equations may be produced that may be solved using numerical methods.

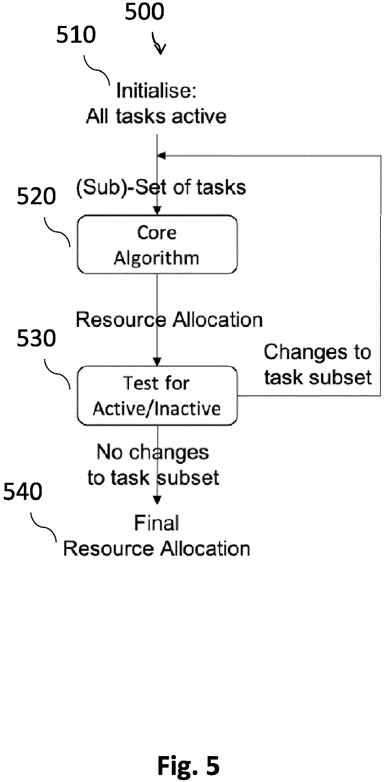

In some examples, the method 100 further comprises deactivating the task and setting the resource to be consumed by the task to 0. This may be useful if not all of the tasks of the group of tasks need to be active, i.e., receive at least a minimum amount of resource in order to achieve a minimum required utility. A total utility may be increased by deactivating some (less prioritized) tasks of the group of tasks so that they may use no resources. In some examples, more than one task of the group of tasks or other tasks than the said task are deactivated. Eventually, the deactivated task may be activated again. Further details about deactivating tasks are described with reference to Fig. 5.

Another example of a resource-utility function is described by Equation 12:

$$u(r_i; \boldsymbol{\theta_i}) = \frac{\theta_{i,1} r_i + \theta_{i,2}}{r_i + \theta_{i,3}} \qquad \text{Equation 12}$$

where $\theta_i = [\theta_{i,1}, \theta_{i,2}, \theta_{i,3}]^T$

An example of a mapping may be generated by using a mapping model and by performing regression. The example of the mapping model is described by Equation 13:

$$h_j(b_i) = \quad \{ \theta_{i,1} = 1.0$$
$$\theta_{i,2} = \rho_1 b_i{}^4 + \rho_2 b_i{}^3 + \rho_3 b_i{}^2 + \rho_4 b_i + \rho_5$$
$$\theta_{i,3} = \theta_{i,2} + (\epsilon_1 b_i{}^4 + \epsilon_2 b_i{}^3 + \epsilon_3 b_i{}^2 + \epsilon_4 b_i + \epsilon_5) \} \qquad \text{Equation 13}$$

where $j$ numbers a task class of the task $i$, $\forall j \in \{1, ..., N_C\}$ and $N_C$ is the number of task classes.

For a search task, $b_i$ of Equation 13 is a scalar representing a required maximum range for the search task. Exemplary parameters $\rho$ for the mapping model are given in the following:

$$\rho_1 = -4.1299 * 10^{-23}$$

$$\rho_2 = -8.3614 * 10^{-18}$$

$$\rho_3 = 4.2750 * 10^{-13}$$

$$\rho_4 = -7.3904 * 10^{-9}$$

$$\rho_5 = 1.3259 * 10^{-5}$$

$$\epsilon_1 = 9.0824 * 10^{-23}$$

$$\epsilon_2 = 5.1193 * 10^{-19}$$

$$\epsilon_3 = -1.7110 * 10^{-14}$$

$$\epsilon_4 = 4.2579 * 10^{-11}$$

$$\epsilon_5 = 8.4003 * 10^{-8}$$

The mapping model of Equation 13 may be used for determining parameters of the resource-utility function of Equation 12 for each task of a group of tasks based on a task state of the task. The mapping may output a set of

parameters $\theta = \{\theta_1, ..., \theta_{NT}\}$ where $\theta_i = [\theta_{i,1}, \theta_{i,2}, \theta_{i,3}]^T$. For example, if a required maximum range for the search task is 45 kilometers (i.e., $b_i$=45000), then $\theta_i$= [1.0, -3.8491$*$10$^{-4}$, 1.5286$*$10$^{-6}$]$^T$.

The KKT multiplier for the resource-utility function of Equation 12 is calculated according to Equation 14:

$$\lambda = \left(\frac{\sum_i \sqrt{\theta_{i,1}\theta_{i,3}-\theta_{i,2}}}{R+\sum_i \theta_{i,3}}\right)^2 \qquad \qquad \text{Equation 14}$$

The resource allocation is calculated based on a solver represented by Equation 15:

$$r_i = \frac{1}{\sqrt{\lambda}} \sqrt{\theta_{i,1}\theta_{i,3} - \theta_{i,2}} - \theta_{i,3} \qquad \qquad \text{Equation 15}$$

Due to a form of the resource-utility function of Equation 12, the solver of Equation 15 has a closed form.

In summary, the method 100 may enable a fast allocation of constrained, finite resources to a group of tasks. The method 100 may decrease computational efforts for generating resource allocations in comparison to conventional resource allocation methods, such as Q-RAM, without losing preciseness in representing realistic task behavior. The method 100 may evade a discretization of a control parameter space. Instead, the method 100 is based on resource-utility function which maps directly from resource to utility, thus, eliminates the need to evaluate the resource function, quality function and utility function for discretized values. With a suitable resource-utility function, an analytic or closed form solution for the resource allocation may be found that requires negligible computation. Parameters for the (parameterized) resource-utility function may be determined using an additional mapping based on a mapping model. The mapping model may be constructed offline which speeds up the resource allocation process online. The mapping model may be a computationally complex model for simulating realistic task and corresponding control parameters. The mapping model may be based on real world data which is solely used in the offline process to construct the mapping model but are no longer needed in the online process. As complex models may be used in the offline process, the online algorithm may be highly representative of the reality with low online computation effort.

**Fig.** 2 illustrates an example of a method 200 for mapping task states of a task to parameters of a resource-utility function. The method 200 may be understood as an offline learning of a mapping which is used for a method for distributing resources among a group of tasks such as method 100.

The method 200 comprises training 210 a mapping model based on a training dataset of at least one exemplary task state of the task and at least one corresponding parameter. The trained mapping model maps the task states of the task to the parameters of the resource-utility function. The method 200 may train a respective mapping model for different task classes, i.e., a mapping model may be learnt for a specific task class. A trained mapping model may be used multiple times by multiple tasks that belong to the specific task class.

The mapping model is represented mathematically by Equation 16:

$$h_j : \mathbf{b}_i \mapsto \boldsymbol{\theta}_i; \ \forall j \in \{1, ..., N_C\} \qquad \qquad \text{Equation 16}$$

where $N_C$ is the number of task classes and $\mathbf{b}_i$ is the task state of task $i$. Alternatively, the mapping model may be independent of the task classes, i.e., there may be one mapping model for several task classes.

Training 210 the mapping model may be performed offline and then the trained mapping model may remain unchanged while it is used online for a resource allocation process. Training 210 the mapping model may be conducted by using any learning technique or functional approximation that may lead to a relationship between the task states and the parameters. In case the mapping model is a machine learning model, training 210 the mapping model may comprise using a machine learning method. In some examples, training 210 the mapping model comprises using a supervised learning method. For instance, the supervised learning method may comprise a regression analysis based on at least one of a varying model, a basis function, a kernel. Alternatively, the mapping model may be trained based on a neural network. In some examples, the mapping model may be learnt by using reinforcement learning. As a simpler implementation, the mapping model may be a look-up table with or without interpolation.

Machine learning may refer to algorithms and statistical models that computer systems may use to perform a specific task without using explicit instructions, instead relying on models and inference. For example, in machine learning, instead of a rule-based transformation of data, a transformation of data may be used, that is inferred from an analysis of historical and/or training data. The training data may be extracted from the training dataset. For example, a mapping between task states of a task and respective parameters of a resource-utility function may be performed using a machine-learning model or using a machine-learning algorithm. In order for the machine-learning model to perform the mapping, the machine-learning model may be trained using training data as input and training content information as output. By training the machine-learning model with a large number of training datapoints and/or training sequences (exemplary task states) and associated training content information (e.g., labels or annotations in form of parameters corresponding to the exemplary task states), the machine-learning model "learns" to recognize a functional relationship between task states and parameters, so that task states that are not included in the training data may be recognized using the machine-learning model.

Machine-learning models may be trained using training input data. In some examples, a training method called "supervised learning" may be used. In supervised learning, the machine-learning model is trained using a plurality of training samples, wherein each sample may comprise a plurality of input data values, and a plurality of desired output values, i.e. each training sample is associated with a desired output value. By specifying both training samples and desired output values, the machine-learning model "learns" which output value to provide based on an input sample that is similar to the samples provided during the training. Apart from supervised learning, semi-supervised learning may be used. In semi-supervised learning, some of the training samples lack a corresponding desired output value. Supervised learning may be based on a supervised learning algorithm (e.g. a classification algorithm, a regression algorithm or a similarity learning algorithm. Classification algorithms may be used when the outputs are restricted to a limited set of values (categorical variables), i.e., the input is classified to one of the limited set of values. Regression algorithms (regression analysis) may be used when the outputs may have any numerical value (within a range). Similarity learning algorithms may be similar to both classification and regression algorithms but are based on learning from examples using a similarity function that measures how similar or related two objects are. Apart from supervised or semi-supervised learning, unsupervised learning may be used to train the machine-learning model. In unsupervised learning, (only) input data might be supplied and an unsupervised learning algorithm may be used to find structure in the input data (e.g., by grouping or clustering the input data, finding commonalities in the data). Clustering is the assignment of input data comprising a plurality of input values into subsets (clusters) so that input values within the same cluster are similar according to one or more (predefined) similarity criteria, while being dissimilar to input values that are included in other clusters.

Reinforcement learning is a third group of machine-learning algorithms. In other words, reinforcement learning may be used to train the machine-learning model. In reinforcement learning, one or more software actors (called "software agents") are trained to take actions in an environment. Based on the taken actions, a reward is calculated. Reinforcement learning is based on training the one or more software agents to choose the actions such, that the cumulative reward is increased, leading to software agents that become better at the task they are given (as evidenced by increasing rewards).

Furthermore, some techniques may be applied to some of the machine-learning algorithms. For example, feature learning may be used. In other words, the machine-learning model may at least partially be trained using feature learning, and/or the machine-learning algorithm may comprise a feature learning component. Feature learning algorithms, which may be called representation learning algorithms, may preserve the information in their input but also transform it in a way that makes it useful, often as a preprocessing step before performing classification or predictions. Feature learning may be based on principal components analysis or cluster analysis, for example.

In some examples, anomaly detection (i.e. outlier detection) may be used, which is aimed at providing an identification of input values that raise suspicions by differing significantly from the majority of input or training data. In other words, the machine-learning model may at least partially be trained using anomaly detection, and/or the machine-learning algorithm may comprise an anomaly detection component.

In some examples, the machine-learning algorithm may use a decision tree as a predictive model. In other words, the machine-learning model may be based on a decision tree. In a decision tree, observations about an item (e.g. a set of input values) may be represented by the branches of the decision tree, and an output value corresponding to the item may be represented by the leaves of the decision tree. Decision trees may support both discrete values and continuous values as output values. If discrete values are used, the decision tree may be denoted a classification tree, if continuous values are used, the decision tree may be denoted a regression tree.

Association rules are a further technique that may be used in machine-learning algorithms. In other words, the machine-learning model may be based on one or more association rules. Association rules are created by identifying relationships between variables in large amounts of data. The machine-learning algorithm may identify and/or utilize one or more relational rules that represent the knowledge that is derived from the data. The rules may e.g. be used to store, manipulate or apply the knowledge.

Machine-learning algorithms are usually based on a machine-learning model. In other words, the term "machine-learning algorithm" may denote a set of instructions that may be used to create, train or use a machine-learning model. The term "machine-learning model" may denote a data structure and/or set of rules that represents the learned knowledge (e.g. based on the training performed by the machine-learning algorithm). In embodiments, the usage of a machine-learning algorithm may imply the usage of an underlying machine-learning model (or of a plurality of underlying machine-learning models). The usage of a machine-learning model may imply that the machine-learning model and/or the data structure/set of rules that is the machine-learning model is trained by a machine-learning algorithm.

For example, the machine-learning model may be an artificial neural network (ANN). ANNs are systems that are inspired by biological neural networks, such as can be found in a retina or a brain. ANNs comprise a plurality of interconnected nodes and a plurality of connections, so-called edges, between the nodes. There are usually three types of nodes, input nodes that receiving input values, hidden nodes that are (only) connected to other nodes, and output nodes that provide output values. Each node may represent an artificial neuron. Each edge may transmit information, from one node to another. The output of a node may be defined as a (non-linear) function of its inputs (e.g. of the sum of its inputs). The inputs of a node may be used in the function based on a "weight" of the edge or of the node that provides the input. The weight of nodes and/or of edges may be adjusted in the learning process. In other words, the training of an artificial neural network may comprise adjusting the weights of the nodes and/or edges of the artificial neural network, i.e., to achieve a desired output for a given input.

Alternatively, the machine-learning model may be a support vector machine, a random forest model or a gradient boosting model. Support vector machines (i.e., support vector networks) are supervised learning models with associated learning algorithms that may be used to analyze data (e.g. in classification or regression analysis). Support vector machines may be trained by providing an input with a plurality of training input values that belong to one of two categories. The support vector machine may be trained to assign a new input value to one of the two categories. Alternatively, the machine-learning model may be a Bayesian network, which is a probabilistic directed acyclic graphical model. A Bayesian network may represent a set of random variables and their conditional dependencies using a directed acyclic graph. Alternatively, the machine-learning model may be based on a genetic algorithm, e.g., a search algorithm and a heuristic technique that mimics a process of natural selection.

Referring back to Fig. 2, the method 200 may optionally comprise generating 220 the training dataset. Alternatively, the training dataset may be a given training dataset.

Generating 220 the training dataset may be based on at least one of a simulation model of a sensor (e.g., an antenna) performing the task, (real) measurements on a sensor when performing the task, or an evaluation of a resource, quality and utility function for the task. These options are described in the following:
In some examples, generating 220 the training dataset comprises inputting the at least one exemplary task state into a simulation model simulating an operation of the task and recording an output of the simulation model. The output may comprise at least one utility achieved by the task and at least one corresponding resource consumed by the task. Generating 220 the training dataset may further comprise determining the at least one parameter corresponding to the at least one exemplary task based on the at least one recorded utility and the at least one corresponding resource.

For instance, generating 220 the training dataset may comprise using numerical processing intensive simulations on a quality function. The training dataset may be generated by a "digital twin", which may be a simulated model of a sensor and its environment. An alternative approach for generating 220 the training dataset may be using a resource function, a quality function, and a utility function as components of a QoS problem.

In some examples, generating 220 the training dataset comprises operating the task with the at least one exemplary task state, and measuring, for the at least one exemplary task state, at least one utility achieved by the task and at least one corresponding resource consumed by the task. Generating 220 the training dataset may further comprise determining the at least one parameter corresponding to the at least one exemplary task based on the at least one measured utility and the at least one corresponding resource.

In other words, real data may be used as training dataset. This may be useful since the mapping model may match well to a real behavior of the sensor.

In some examples, generating 220 the training dataset comprises determining, for the at least one exemplary task state, at least one high utility of the task for at least one corresponding resource to be consumed by the task and determining the at least one parameter corresponding to the at least one exemplary task based on the at least one determined high utility and the at least one corresponding resource. The high utility of the task may be a maximum or Pareto efficient utility. The at least one parameter may be determined by approximating a concave majorant of a convex hull around the resource-utility instantiations comprising the at least one high utility of the task and the at least one corresponding resource.

For instance, determining the at least one high utility of the task may comprise applying a non-linear optimizer to at least one of a utility function, a quality function, a resource function.

Exemplary steps for generating 220 the dataset are listed in the following:

1) Select a task state for a task in a given task class.
2) For a set of resource values, find a maximum utility that the task may achieve with each of the resource values. For example, a non-linear optimizer may be run on the quality function, the utility function, and the resource function. Step 2 may produce a set of utility values comprising a respective utility value for each of the resource values.
3) Fit the resource-utility function to the resource and utility values to find parameters of the resource-utility function.
4) Store a pairing of the task state and corresponding parameters of the resource-utility function as a data point.

5) Repeat step 1 to step 4 with different task states to produce a training dataset of data points. Step 1 to step 4 may be repeated until the training dataset achieves a sufficient size. Requirements regarding the size of the dataset may be dependent on the mapping model and the learning method.

6) Repeat step 1 to step 5 for all task classes to produce a respective training dataset for each task class that may be used for finding a mapping $h_j$ for each task class.

The method 200 may allow generating a (direct) mapping between task classes and parameters of a resource-utility function. This may speed up resource allocation processes, e.g., in multifunctional radio frequency systems, computing systems, radar systems, or telecommunication systems. Moreover, the method 200 may allow constructing a mapping model offline, thus, less computation effort may be needed in an online process (e.g., method 100). The method 200 may enable a usage of complex realistic models (based on measured data, a digital twin, or precisely calculated data) for simulating a behavior of tasks without increasing computation efforts in the online process. Hence, the method 200 may increase an accuracy of a reproduction of the behavior of tasks.

Fig. 3 illustrates an example of an apparatus 300 for distributing resources among a group of tasks 310. The apparatus 300 comprises processing circuitry 320 configured to determine at least one parameter, such as parameters 331 and 332, of a resource-utility function 340 for a task 311 of the group of tasks 310 based on a task state of the task 311.

The processing circuitry 320 may, for instance, be a single dedicated processor, a single shared processor, or a plurality of individual processors, some of which or all of which may be shared, a digital signal processor (DSP) hardware, an application specific integrated circuit (ASIC) or a field programmable gate array (FPGA). The processing circuitry 320 may optionally be coupled to, e.g., read only memory (ROM) for storing software, random access memory (RAM) and/or non-volatile memory. The processing circuitry 320 is configured to perform at least part of processes described herein, such as, determining the at least one parameter of the resource-utility function 340.

For instance, the processing circuitry 320 may be communicatively coupled to a multifunctional radio frequency system. The processing circuitry 320 may act as a resource manager of the multifunctional radio frequency system. The processing circuitry 320 may receive the task state as input and a request to distribute the resources among the group of tasks 310 from the multifunctional radio frequency system. The processing circuitry 320 may be able to access data indicating a current state of a resource budget available for distributing among the group of resources 310.

The processing circuitry 320 may determine the parameters 331, 332 based on a mapping between the task state of the task 311 and parameters of the resource-utility function 340. The mapping may be specific for a task class of the task 311, i.e., the processing circuitry 320 may receive data indicating the task class of the task 311 from the multifunctional radio frequency system and retrieve a corresponding mapping, e.g., from a database associating task classes with mappings.

The processing circuitry 320 may determine parameters of the resource-utility function 340 for further tasks of the group of tasks 310, e.g., task 312 or task 313, in a similar way as described for the task 311.

The processing circuitry 320 is further configured to determine a resource 350 to be consumed by the task 311 based on the resource-utility function 340. For instance, the processing circuitry 320 may calculate an output of the resource-utility function 340 based on the determined parameters 331, 332.

The processing circuitry 320 may determine the resource 350 by solving a combined resource-utility function of further or all (active) tasks of the group of tasks 310. Therefore, the processing circuitry 320 may determine parameters of the resource-utility function 340 for further or all tasks of the group of tasks 310. The processing circuitry 320 may run a solver on the combined resource-utility function (a constrained optimization problem) for finding a maximum total utility of the further or of all tasks which is achievable with the current available resource budget, i.e., without exceeding a predefined threshold.

The processing circuitry 320 may transmit data indicating the determined resource 350 to the multifunctional radio frequency system which may, then, assign the resource 350, e.g., a share of a power budget, to the task 311. The multifunctional radio frequency system may adjust a sensor (antenna) according to control parameters of the task 311. The control parameters may depend on the determined resource 350 of the task 311.

In some examples, the apparatus 300 may be for a multifunctional radio frequency system. In other examples, the apparatus 300 may be for any other system which require resource allocations, e.g., a computing system or a telecommunication system.

In some examples, the processing circuitry 320 may be configured to determine the at least one parameter of the resource-utility function 340 by mapping the task state of the task 311 to the at least one parameter using a mapping model. The mapping model may be at least one of a function, a function approximation, a look-up table.

In some examples, the processing circuitry 320 may be configured to determine the at least one parameter of the resource-utility function 340 by determining at least one resource-utility instantiation for the task state, approximating a convex hull around the at least one resource-utility instantiation and determining the at least one parameter based on the approximated convex hull.

In some examples, the processing circuitry 320 may be configured to determine the resource 350 to be consumed by the task 311 by determining resources to be consumed by further tasks, e.g., task 312, 313, of the group of tasks 310 without the resources to be distributed among the group of tasks 310 exceeding a predefined threshold.

In some examples, the processing circuitry 320 may be configured to determine the resources to be consumed by the further tasks of the group of tasks 310 by solving a Lagrangian function for finding a maximum of a combined resource-utility function of the group of tasks 310. In some examples, the processing circuitry 320 may be configured to solve the Lagrangian function by using at least one of an analytical solver, a closed form solver, a numerical solver.

In some examples, the processing circuitry 320 may be configured to determine at least one control parameter of the task 311 based on the determined resource 350 to be consumed by the task 311.

In some examples, the resources to be distributed among the group of tasks may be of different types, the processing circuitry 320 may be further configured to determine, for each of the different types, a respective resource to be consumed by the task 311 based on the resource-utility function 340.

In some examples, the processing circuitry 320 may be further configured to deactivate the task 311 and set the resource 350 to be consumed by the task 311 to 0.

More details and aspects of the apparatus 300 are explained in connection with a proposed technique or one or more examples described herein, e.g., with reference to Fig. 1. The apparatus 300 may comprise one or more additional optional features corresponding to one or more aspects of the proposed technique, or one or more examples described herein.

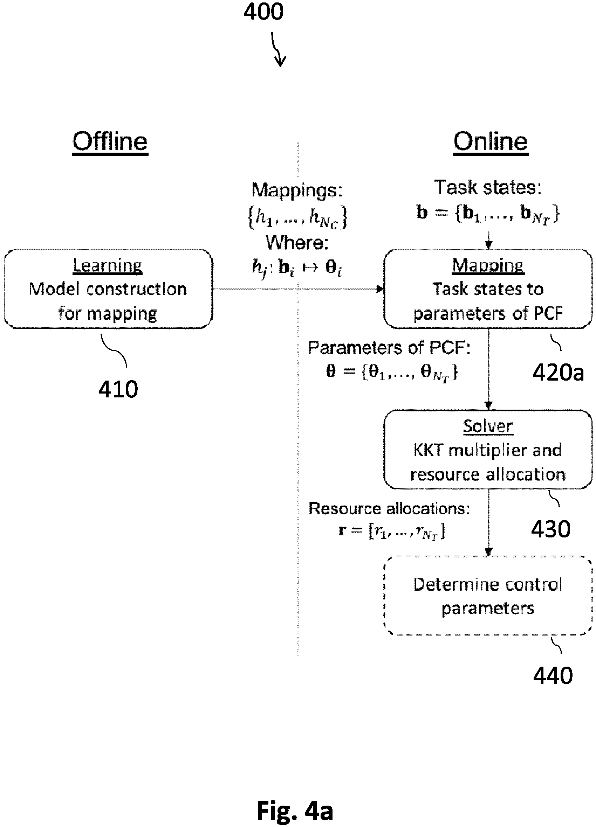

**Fig. 4a** and **Fig. 4b** illustrate a flowchart of examples of a method 400 to distribute resources among a group of tasks in a combined offline and online process (Fig. 4a) and in a solely online process (Fig. 4b).

The offline process of Fig. 4a comprises a process step learning 410 in which mappings (denoted as h) are constructed for a set of task classes. The mappings may provide a functional relationship between task states (denoted as b) and parameters (denoted as $\theta$) of a parameterized concave function (denoted as PCF). The PCF may be a resource-utility function for a resource allocation process. learning 410 may be performed independent of the online process, e.g., before the online process or in a different system than the one performing the online process. The mappings h of the learning 410 is input to a process step mapping 420a of the online process. Further process steps of the method 400 are part of the online process.

Task states $\mathbf{b}_1$, ..., $\mathbf{b}_{NT}$ of current tasks are input to the mapping 420a. The mapping 420a uses the mappings $h_i$, ..., $h_{NC}$ according to task classes of the current tasks and outputs parameters $\theta_1$, ..., $\theta_{NT}$ of the PCF for each of the current tasks based on a respective task state.

The parameters are input to a process step solver 430. The solver 430 determines KKT multipliers for a Lagrangian function and determine a resource allocation (denoted as r) based on the Lagrangian function. The Lagrangian function may represent an optimization of a utility of tasks considering a limited resource budget. In other words, the solver 430 solves the dual problem and stationarity condition of a constrained optimization problem.

The resource allocation is input of an optional process step 440. In the process step 440, control parameters are determined. After each of the current tasks has been allocated a resource r, the control parameters for each of the current tasks may be found. The control parameters may be found using a non-linear optimizer or by learning a model that maps between the resource allocation and the control parameters.

The method 400 of Fig. 4b omits the offline process step 410 of Fig. 4a. Moreover, the mapping 420a of Fig. 4a is replaced by a mapping 420b. The mapping 420b takes as input the task states and outputs the parameters $\theta$ of the PCF. The mappings h may be determined online, e.g., by evaluating a small number of control parameters (based on a resource function, quality function, and utility function) and extracting a concave majorant of the control parameters. The PCF may then be fitted to the concave majorant to find the parameters $\theta$.

Similarly to Fig. 4b, the method 400 of Fig. 4b continues with the process steps 430 and 440.

**Fig. 5** illustrates a flowchart of an example of a method 500 to distribute resources among a group of tasks. The method 500 may be used in case a deactivation (and activation) of tasks is provided.

The method 500 comprises initializing the method 500 by setting all tasks of the group of tasks to active. The method 500 comprises performing 520 a core algorithm with a current set of tasks. The core algorithm may refer to a resource allocation method, such as method 100.

After performing 520 the core algorithm, the method 500 performs testing 530 for active/inactive tasks. For instance, the method 500 may record tasks of the group of tasks which are activated/deactivated since the latest performing 520 of the core algorithm and check whether changes to the current set of active tasks are needed.

If no tasks are recorded, a final resource allocation 540 is determined. If tasks are recorded, the method 500 adds newly activated tasks to the current set of active tasks and deletes newly deactivated tasks from the current set of active tasks. Then, the method 500 loops back to performing 520 the core algorithm.

In summary, the present invention provides methods and apparatuses for a resource allocation based on a resource-utility function. The resource-utility function may remove a need to perform a discretization of a control parameter space and a resource space. Consequently, the methods and apparatuses may decrease an approximation loss due to discretization compared to conventional resource allocation methods. Additionally, the resource-utility function may allow finding a solution in closed or analytic form, or with efficient numerical methods. Thus, the methods and apparatuses may reduce online computation time since an online numerical convex hull computation or iterative calculations may be omitted.

The methods and apparatuses may completely skip an online evaluation of a quality function or perform only few evaluations of the quality function, hence reducing computation efforts. If a mapping model for the resource allocation is constructed offline, highly representative simulations for the quality function or real data may be used for the model construction. The resource allocation provided by the methods and apparatuses may, thus, match well the reality.

The present invention may enable QoS based resource allocation processes which may be useful for an implementation in real-time sensors with limited computational resources.

The figures below illustrate simulations of concrete examples and are for illustration purposes only.

**Fig. 6a, Fig. 6b** and **Fig. 6c** illustrate a first example of a resource function 600a (Fig. 6a), a quality function 600b (Fig. 6b) and a utility function 600c (Fig. 6c). **Fig. 7a, Fig. 7b** and **Fig. 7c** illustrate a second example of a resource function 700a (Fig. 7a), a quality function 700b (Fig. 7b) and a utility function 700c (Fig. 7c).

The resource function takes the task control parameters of the task and the task state of the task as inputs and outputs a real value representing a resource that the task requires.

The quality function takes the task control parameters of the task and the task state of the task as input and outputs a real value representing a quality that the task achieves. Different quality measures and associated functions may be used for different task classes. For example, for a tracking task, a predicted track accuracy may be taken as the quality measure. It is to be noted, that - although it is termed a function - the quality function is not necessarily an analytic mathematical expression. Instead, in some examples, the quality function is a numerical method (which may require substantial computation).

The utility function is used to calculate the utility associated with the quality that the search task achieves. For instance, the utility function may map from the quality value into a real value bounded between 0 and 1. A utility function may be useful to specify quality requirements, allow a comparison between different quality measurements, or to enable different quality measurements to be combined into a single objective for optimization. The utility function may incorporate a weighting indicating a differing importance (or different priorities) of different tasks.

The first example and the second example refer to a first search task and a second search task (with different beam positions and different beam angles), respectively, of a multifunctional radio frequency system. Control parameters of the first search task and the second search task are revisit interval time and dwell time. A task state of the first search task and the second search task comprises a required maximum range for the search which is 60 km in the first example and 45 km in the second example.

The quality functions 600b and 700b are generated based on an expected time for detecting a target at the maximum range. The utility functions 600c and 700c are linearly decreasing functions between 0 and 30s, mapping quality to a value between 0 and 1.

A resource allocation for the first search task and the second search task may be considered a QoS problem which may be described as a constrained optimization problem, whereby a resource is allocated, and control parameters are selected for the tasks such that a summation of a utility of the tasks is maximized given a maximum available resource is not exceeded.

The resource, quality and utility functions are used to produce a resource-against-utility plot for the first search task and the second search task based on a respective current task state. A first exemplary resource-against-utility plot 800a for the first search task is illustrated by Fig. **8a.** A second exemplary resource-against-utility plot 800b for the second search task is illustrated by **Fig. 8b**. The plots are produced by evaluating the resource functions 600a and 700a, the quality functions 600b and 700b and the utility functions 600c and 700c for discretized values of control parameters (in the control parameter space). Each of dots illustrated in the plots of Fig. 8a and Fig. 8b is a certain resource-utility-instantiation (or control parameter instantiation, i.e., a specific combination of dwell time and revisit interval). Dots marked with a circle in Fig. 8a and Fig. 8b represent a concave majorant which are points along the upper convex hull, i.e., the marked dots represent resource-utility-instantiations with a high (or highest) utility among utilities associated with a certain resource.

The curve approximating the concave majorant in Fig. 8a and Fig. 8b is an example of a resource-utility function fitted to the concave majorant, i.e., with determined parameters.

Conventionally, the QoS problem may be solved using a Q-RAM algorithm. The Q-RAM algorithm performs a discretization of the actually continuous control parameter space in order to produce a finite set of control parameter instantiations for each task. Then, the resource function (600a, 700a), the quality function (600b, 700b) and the utility functions (600c, 700c) are used to calculate resource and utility values for each control parameter instantiation for each task. The considered control parameter instantiations are reduced to those lying on the concave majorant. Then, starting from the control parameter instantiations requiring the least resource, additional resource is iteratively allocated to the task such that a good payoff in terms of utility per resource is achieved when moving to a next control parameter instantiation on the concave majorant (nearest to and right of the starting control parameter instantiation). The iterative allocation is repeated until there is not enough resource available for any task to reach the next control parameter instantiation on the respective concave majorant.

Unlike the Q-RAM algorithm, the present invention may suggest a resource allocation process based on a (continuous) resource-utility function instead of a discretization. This may enable a faster and more representative resource allocation process.

The following examples pertain to further embodiments:

Embodiment (1) is a method to distribute resources among a group of tasks. The method of embodiment (1) comprises determining at least one parameter of a resource-utility function for a task of the group of tasks based on a task state of the task and determining a resource to be consumed by the task based on the resource-utility function.

Embodiment (2) is the method of embodiment (1) wherein the method is for a multifunctional radio frequency radar system.

Embodiment (3) is the method of embodiment (1) or embodiment (2) wherein the resource-utility function is a concave continuous function.

Embodiment (4) is the method of any one of the embodiments (1) to (3) wherein the resource-utility function approximates a convex hull around at least one resource-utility instantiation of the task.

Embodiment (5) is the method of any one of the embodiments (1) to (4) wherein determining the at least one parameter of the resource-utility function comprises mapping the task state of the task to the at least one parameter using a mapping model.

Embodiment (6) is the method of embodiment (5) wherein the mapping model is at least one of a function, a function approximation, a look-up table.

Embodiment (7) is the method of embodiment (5) wherein mapping the task state of the task to the at least one parameter comprises determining at least one resource-utility instantiation for the task state, approximating a convex hull around the at least one resource-utility instantiation and determining the at least one parameter based on the approximated convex hull.

Embodiment (8) is the method of any one of the embodiments (1) to (7) wherein determining the resource to be consumed by the task comprises determining resources to be consumed by further tasks of the group of tasks without the resources to be distributed among the group of tasks exceeding a predefined threshold.

Embodiment (9) is the method of embodiment (8) wherein determining the resources to be consumed by the further tasks of the group of tasks comprises solving a Lagrangian function for finding a maximum of a combined resource-utility function of the group of tasks.

Embodiment (10) is the method of embodiment (9) wherein solving the Lagrangian function comprises using at least one of an analytical solver, a closed form solver, a numerical solver.

Embodiment (11) is the method of any one of the embodiments (1) to (10) wherein the method further comprises determining at least one control parameter of the task based on the determined resource to be consumed by the task.

Embodiment (12) is the method of any one of the embodiments (1) to (11) wherein the resources to be distributed among the group of tasks are of different types and wherein the method further comprises determining, for each of the different types, a respective resource to be consumed by the task based on the resource-utility function.

Embodiment (13) is the method of any one of the embodiments (1) to (12) wherein the method further comprises deactivating the task and setting the resource to be consumed by the task to 0.

Embodiment (14) is a method for mapping task states of a task to parameters of a resource-utility function. The method of embodiment (14) comprises training a mapping model based on a training dataset of at least one exemplary task state of the task and at least one corresponding parameter wherein the trained mapping model maps the task states of the task to the parameters.

Embodiment (15) is the method of embodiment (14) wherein the method further comprises generating the training dataset wherein generating the training dataset comprises inputting the at least one exemplary task state into a simulation model simulating an operation of the task, recording an output of the simulation model comprising at least one utility achieved by the task and at least one corresponding resource consumed by the task and determining the at least one parameter corresponding to the at least one exemplary task based on the at least one recorded utility and the at least one corresponding resource.

Embodiment (16) is the method of embodiment (14) wherein the method further comprises generating the training dataset wherein generating the training dataset comprises operating the task with the at least one exemplary task state, measuring, for the at least one exemplary task state, at least one utility achieved by the task and at least one corresponding resource consumed by the task and determining the at least one parameter corresponding to the at least one exemplary task based on the at least one measured utility and the at least one corresponding resource.

Embodiment (17) is the method of embodiment (14) wherein the method further comprises generating the training dataset wherein generating the training dataset comprises determining, for the at least one exemplary task state, at least one high utility of the task for at least one corresponding resource to be consumed by the task and determining the at least one parameter corresponding to the at least one exemplary task based on the at least one determined high utility and the at least one corresponding resource.

Embodiment (18) is the method of embodiment (17) wherein determining the at least one high utility of the task comprises applying a non-linear optimizer to at least one of a utility function, a quality function, a resource function.

Embodiment (19) is the method of any one of the embodiments (14) to (18) wherein training the mapping model comprises using a supervised learning method.

Embodiment (20) is the method of embodiment (19) wherein the supervised learning method comprises a regression analysis based on at least one of a varying model, a basis function, a kernel.

Embodiment (21) is an apparatus for distributing resources among a group of tasks wherein the apparatus comprises processing circuitry configured to determine at least one parameter of a resource-utility function for a task of the group of tasks based on a task state of the task and determine a resource to be consumed by the task based on the resource-utility function.

Embodiment (22) is the apparatus of embodiment (21) wherein the apparatus is for a multifunctional radar system.

Embodiment (23) is the apparatus of embodiment (21) or (22) wherein the resource-utility function is a concave continuous function.

Embodiment (24) is the apparatus of any one of embodiments (21) to (23) wherein the resource-utility function approximates a convex hull around at least one re-source-utility instantiation of the group of tasks.

Embodiment (25) is the apparatus of any one of embodiments (21) to (24) wherein the processing circuitry is configured to determine the at least one parameter of the resource-utility function by mapping the task state of the task to the at least one parameter using a mapping model.

Embodiment (26) is the apparatus of embodiment (25) wherein the mapping model is at least one of a function, a function approximation, a look-up table.

Embodiment (27) is the apparatus of any one of embodiment (21) to (25) wherein the processing circuitry is configured to determine the at least one parameter of the resource-utility function by determining at least one resource-utility instantiation for the task state, approximating a convex hull around the at least one resource-utility instantiation and determining the at least one parameter based on the approximated convex hull.

Embodiment (28) is the apparatus of any one of embodiments (21) to (27) wherein the processing circuitry is configured to determine the resource to be consumed by the task by determining resources to be consumed by further tasks of the group of tasks without the resources to be distributed among the group of tasks exceeding a predefined threshold.

Embodiment (29) is the apparatus of embodiment (28) wherein the processing circuitry is further configured to determine the resources to be consumed by the further tasks of the group of tasks by solving a Lagrangian function for finding a maximum of a combined resource-utility function of the group of tasks.

Embodiment (30) is the apparatus of embodiment (29) wherein the processing circuitry is further configured to solve the Lagrangian function by using at least one of an analytical solver, a closed form solver, a numerical solver.

Embodiment (31) is the apparatus of any one of embodiments (21) to (30) wherein the processing circuitry is further configured to determine at least one control parameter of the task based on the determined resource to be consumed by the task.

Embodiment (32) is the apparatus of any one of embodiments (21) to (31) wherein the resources to be distributed among the group of tasks are of different types and wherein the processing circuitry is further configured to determine, for each of the different types, a respective resource to be consumed by the task based on the resource-utility function.

Embodiment (33) is the apparatus of any one of embodiments (21) to (32) wherein the processing circuitry is further configured to deactivate the task and set the resource to be consumed by the task to 0.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor, or other programmable hardware component. Thus, steps, operations, or processes of different ones of the methods described above may also be executed by programmed computers, processors, or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations, or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process, or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

**Claims**

1. A method to distribute resources among a group of tasks, comprising:

   determining at least one parameter of a resource-utility function for a task of the group of tasks based on a task state of the task; and

determining a resource to be consumed by the task based on the resource-utility function.

2. The method of claim 1,
   wherein determining the at least one parameter of the resource-utility function comprises mapping the task state of the task to the at least one parameter using a mapping model.

3. The method of claim 2,
   wherein mapping the task state of the task to the at least one parameter comprises:

   determining at least one resource-utility instantiation for the task state;
   approximating a convex hull around the at least one resource-utility instantiation; and
   determining the at least one parameter based on the approximated convex hull.

4. The method of any one of the previous claims,
   wherein determining the resource to be consumed by the task comprises determining resources to be consumed by further tasks of the group of tasks without the resources to be distributed among the group of tasks exceeding a predefined threshold.

5. The method of claim 4,
   wherein determining the resources to be consumed by the further tasks of the group of tasks comprises solving a Lagrangian function for finding a maximum of a combined resource-utility function of the group of tasks.

6. A method for mapping task states of a task to parameters of a resource-utility function, comprising:

   training a mapping model based on a training dataset of at least one exemplary task state of the task and at least one corresponding parameter,
   wherein the trained mapping model maps the task states of the task to the parameters.

7. The method of claim 6, further comprising:
   generating the training dataset, comprising:

   inputting the at least one exemplary task state into a simulation model simulating an operation of the task;
   recording an output of the simulation model comprising at least one utility achieved by the task and at least one corresponding resource consumed by the task; and
   determining the at least one parameter corresponding to the at least one exemplary task based on the at least one recorded utility and the at least one corresponding resource.

8. The method of claim 6, further comprising:
   generating the training dataset, comprising:

   operating the task with the at least one exemplary task state;
   measuring, for the at least one exemplary task state, at least one utility achieved by the task and at least one corresponding resource consumed by the task; and
   determining the at least one parameter corresponding to the at least one exemplary task based on the at least one measured utility and the at least one corresponding resource.

9. The method of claim 6, further comprising:
   generating the training dataset, comprising:

   determining, for the at least one exemplary task state, at least one high utility of the task for at least one corresponding resource to be consumed by the task; and
   determining the at least one parameter corresponding to the at least one exemplary task based on the at least one determined high utility and the at least one corresponding resource.

10. An apparatus for distributing resources among a group of tasks, comprising:
    processing circuitry configured to:

    determine at least one parameter of a resource-utility function for a task of the group of tasks based on a task state of the task; and
determine a resource to be consumed by the task based on the resource-utility function.

11. The apparatus of claim 10,
    wherein the processing circuitry is configured to determine the at least one parameter of the resource-utility function
    by mapping the task state of the task to the at least one parameter using a mapping model.

12. The apparatus of claim 10 or 11,
    wherein the processing circuitry is configured to determine the at least one parameter of the resource-utility function
    by:

    determining at least one resource-utility instantiation for the task state;
    approximating a convex hull around the at least one resource-utility instantiation; and
    determining the at least one parameter based on the approximated convex hull.

13. The apparatus of any one of claims 10 to 12,
    wherein the processing circuitry is configured to determine the resource to be consumed by the task by determining
    resources to be consumed by further tasks of the group of tasks without the resources to be distributed among the
    group of tasks exceeding a predefined threshold.

14. The apparatus of claim 13,
    wherein the processing circuitry is further configured to determine the resources to be consumed by the further
    tasks of the group of tasks by solving a Lagrangian function for finding a maximum of a combined resource-utility
    function of the group of tasks.

15. The apparatus of any one of claims 10 to 14,

    wherein the resources to be distributed among the group of tasks are of different types, and
    wherein the processing circuitry is further configured to determine, for each of the different types, a respective
    resource to be consumed by the task based on the resource-utility function.

100

determining at least one parameter of a resource-utility function for a task of a group of tasks based on a task state of the task

110

determining a resource to be consumed by the task based on the resource-utility function

120

**Fig. 1**

200

generating a training dataset

220

training a mapping model based on the training dataset of at least one exemplary task state of a task and at least one corresponding parameter

210

**Fig. 2**

**Fig. 3**

**400**

**Offline**

**Online**

Mappings:
$\{h_1, \dots, h_{N_C}\}$
Where:
$h_j: \mathbf{b}_i \mapsto \boldsymbol{\theta}_i$

Task states:
$\mathbf{b} = \{\mathbf{b}_1, \dots, \mathbf{b}_{N_T}\}$

**Learning**
Model construction
for mapping

**Mapping**
Task states to
parameters of PCF

**410**

**420a**

Parameters of PCF:
$\boldsymbol{\theta} = \{\boldsymbol{\theta}_1, \dots, \boldsymbol{\theta}_{N_T}\}$

**Solver**
KKT multiplier and
resource allocation

**430**

Resource allocations:
$\mathbf{r} = [r_1, \dots, r_{N_T}]$

Determine control
parameters

**440**

**Fig. 4a**

400

## Online

Task states:

$$\mathbf{b} = \{\mathbf{b}_1, \ldots, \mathbf{b}_{N_T}\}$$

Mapping
Task states to
parameters of PCF

420b

Parameters of PCF:

$$\boldsymbol{\theta} = \{\boldsymbol{\theta}_1, \ldots, \boldsymbol{\theta}_{N_T}\}$$

Solver
KKT multiplier and
resource allocation

430

Resource allocations:

$$\mathbf{r} = [r_1, \ldots, r_{N_T}]$$

Determine control
parameters

440

## Fig. 4b

Fig. 5

**Example Evaluation of Resource Function**

Resource - time budget (%)

Dwell duration (ms)

Revisit interval (s)

Fig. 6a

600a

**Example Evaluation of Quality Function**

Expected Maximum Time to Detection (s)

Dwell duration (ms)

Revisit interval (s)

600b

Fig. 6b

Example Evaluation of Utility Function

Utility

Dwell duration (ms)

Revisit interval (s)

600c

Fig. 6c

Example Evaluation of Resource Function

700a

Fig. 7a

Example Evaluation of Quality Function

700b

Fig. 7b

Example Evaluation of Utility Function

700c

Fig. 7c

**Resource - Utility**

800a

Fig. 8a

**Resource - Utility**

800b

Fig. 8b

Europäisches
Patentamt

European
Patent Office

Office européen
des brevets

# EUROPEAN SEARCH REPORT

Application Number

EP 21 20 2205

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/324822 A1 (GOTTIN VINÍCIUS MICHEL [BR] ET AL) 24 October 2019 (2019-10-24) * abstract * * paragraph [0005] * * paragraph [0018] – paragraph [0102] * | 1-15 | INV. G06F9/50 G06F30/20 G06F30/27 |
| X | DURST SEBASTIAN ET AL: "Quality of service based radar resource management using deep reinforcement learning", 2021 IEEE RADAR CONFERENCE (RADARCONF21), IEEE, 7 May 2021 (2021-05-07), pages 1-6, XP033925839, DOI: 10.1109/RADARCONF2147009.2021.9455234 [retrieved on 2021-06-14] * Sections II, III, IV * | 1-15 | |
| X | CHARLISH ALEXANDER ET AL: "The Development From Adaptive to Cognitive Radar Resource Management", IEEE AEROSPACE AND ELECTRONIC SYSTEMS MAGAZINE., [Online] vol. 35, no. 6, 1 June 2020 (2020-06-01), pages 8-19, XP055896218, US ISSN: 0885-8985, DOI: 10.1109/MAES.2019.2957847 Retrieved from the Internet: URL:https://ieeexplore.ieee.org/stampPDF/g etPDF.jsp?tp=&arnumber=9109776&ref=aHR0cHM 6Ly9pZWVleHBsb3JlLmllZWUub3JnL2Fic3RyYWN0L 2RvY3VtZW50LzkxMDk3NzY=> [retrieved on 2022-02-28] * page 13 – page 17 * | 1-15 | TECHNICAL FIELDS SEARCHED (IPC) G06F |

The present search report has been drawn up for all claims

| Place of search | Date of completion of the search | Examiner |
|---|---|---|
| The Hague | 1 March 2022 | Touloupis, Emmanuel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 20 2205

This annex lists the patent family members relating to the patent documents cited in the above-mentioned European search report.
The members are as contained in the European Patent Office EDP file on
The European Patent Office is in no way liable for these particulars which are merely given for the purpose of information.

01-03-2022

| Patent document cited in search report | Publication date | Patent family member(s) | Publication date |
|---|---|---|---|
| US 2019324822 A1 | 24-10-2019 | NONE | |

For more details about this annex : see Official Journal of the European Patent Office, No. 12/82